# EUROPEAN PATENT APPLICATION

(11) **EP 4 727 316 A1**
(43) Date of publication of application: **15.04.2026**
(21) Application number: 24832542.5
(22) Date of filing: 15.02.2024
(51) Int. Cl.: H10K 59/80, G09F 9/33

(54) **DISPLAY DEVICE**

(30) Priority: 29.06.2023 WO PCT/KR2023/009079; 05.09.2023 KR 20230117878
(71) Applicant: LG Electronics Inc., Yeongdeungpo-gu Seoul 07336 (KR)
(72) Inventor: SHIN, Dongho, Seoul 06772 (KR); LEE, Kyoungjoon, Seoul 06772 (KR); LEE, Minchul, Seoul 06772 (KR)
(74) Representative: Schornack, Oliver
(86) International application number: PCT/KR2024/095207
(87) International publication number: WO 2025/005766

(57) **Abstract**

A display device is disclosed. The display device of the present disclosure may include: a display panel; a frame which is located behind the display panel and to which the display panel is coupled; a board including a substrate and seated on the frame; and a shield covering the board, wherein the board may include an element which protrudes from the substrate toward the shield and on which the shield is seated, and one of the substrate and the shield may include protruding parts which protrude from the one to the other to be inserted into the other, which and are spaced apart from each other.

## Description

### TECHNICAL FIELD

The present disclosure relates to a display device.

### BACKGROUND ART

As the information society develops, the demand for display devices is also increasing in various forms, and in response to this, various display devices such as Liquid Crystal Display Device (LCD), Plasma Display Panel (PDP), Electro luminescent Display (ELD), and Vacuum Fluorescent Display (VFD), have been studied and used recently.

Among these, the LCD panel has a TFT substrate and a color substrate that are opposite to each other with a liquid crystal layer interposed therebetween, and may display images by using light provided from a backlight unit. In addition, an OLED panel may display images by depositing an organic layer that can emit light naturally on a substrate on which a transparent electrode is formed.

A source PCB provides digital video data and a timing control signal received from a timing controller board to a display panel. A shield may cover and protect the timing controller board, and may be fixed to the timing controller board and a frame by using screws. However, since the position of the shield seated on the component(s) on the timing controller board is not fixed, there is a problem that a lot of manpower is required to fasten the screws to the shield, and there is also a problem that it is difficult to use an automatic fastener.

### DETAILED DESCRIPTION OF INVENTION

### TECHNICAL PROBLEMS

It is an objective of the present disclosure to solve the above and other problems.

Another object may be to provide a structure capable of minimizing the movement of a shield seated on a timing controller board before screw fastening.

Another object may be to provide a structure for minimizing shield movement that is compatible with shields of different thicknesses.

Another object may be to provide various examples of a structure for minimizing shield movement.

### TECHNICAL SOLUTION

According to an aspect of the present disclosure for achieving the above or other object, a display device may include: a display panel; a frame which is located behind the display panel, and to which the display panel is coupled; a board including a substrate, and seated on the frame; and a shield covering the board, in which the board may include an element which protrudes from the substrate toward the shield, and on which the shield is seated, and one of the substrate and the shield may include protrusions which protrude from the one to the other to be inserted into the other, and which are spaced apart from each other.

### EFFECT OF INVENTION

The display device according to the present disclosure has the following effects.

According to at least one embodiment of the present disclosure, there may be provided a structure capable of minimizing the movement of a shield seated on a timing controller board before screw fastening.

According to at least one embodiment of the present disclosure, there may be provided a structure for minimizing shield movement that is compatible with shields of different thicknesses.

According to at least one embodiment of the present disclosure, there may be provided various examples of a structure for minimizing shield movement.

Further scope of applicability of the present disclosure will become apparent from the detailed description given hereinafter. However, it should be understood that the detailed description and specific examples, while indicating preferred embodiments of the present disclosure, are given by illustration only, since various changes and modifications within the spirit and scope of the present disclosure will become apparent to those skilled in the art from this detailed description.

### BRIEF DESCRIPTION OF THE DRAWING

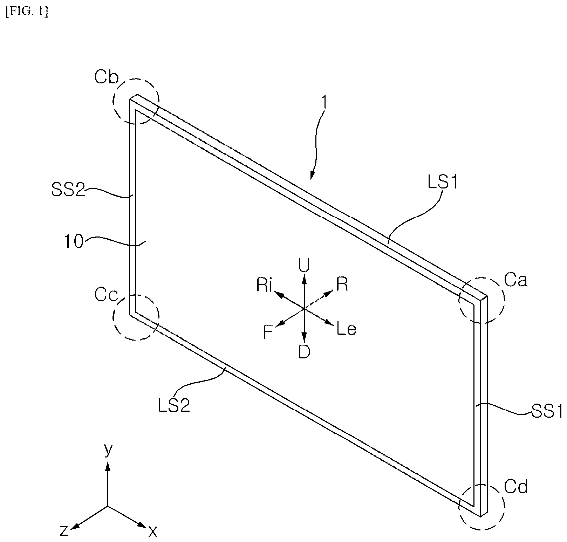

FIGS. 1 to 29 are diagrams illustrating examples of a display device according to embodiments of the present disclosure.

### MODE FOR CARRYING OUT THE INVENTION

Description will now be given in detail according to exemplary embodiments disclosed herein, with reference to the accompanying drawings. For the sake of brief description with reference to the drawings, the same or equivalent components may be denoted by the same reference numbers, and description thereof will not be repeated.

In general, suffixes such as "module" and "unit" may be used to refer to elements or components. Use of such suffixes herein is merely intended to facilitate description of the specification, and the suffixes do not have any special meaning or function.

In the present disclosure, that which is well known to one of ordinary skill in the relevant art has generally been omitted for the sake of brevity. The accompanying drawings are used to assist in easy understanding of various technical features and it should be understood that the embodiments presented herein are not limited by the accompanying drawings. As such, the present disclosure should be construed to extend to any alterations, equivalents and substitutes in addition to those which are particularly set out in the accompanying drawings.

It will be understood that although the terms first, second, etc. may be used herein to describe various elements, these elements should not be limited by these terms. These terms are only used to distinguish one element from another.

It will be understood that when an element is referred to as being "connected with" another element, there may be intervening elements present. In contrast, it will be understood that when an element is referred to as being "directly connected with" another element, there are no intervening elements present.

A singular representation may include a plural representation unless context clearly indicates otherwise.

In the present application, it should be understood that the terms "comprises, includes," "has," etc. specify the presence of features, numbers, steps, operations, elements, components, or combinations thereof described in the specification, but do not preclude the presence or addition of one or more other features, numbers, steps, operations, elements, components, or combinations thereof.

The direction indications of up U, down D, left Le, right Ri, front F, and rear R shown in the drawings are only for the convenience of explanation, and the technical concepts disclosed in this specification are not limited thereby.

A display device of the present disclosure may include various types of display panels, such as an OLED panel described below with reference to FIGS. 2 to 6 or an LCD panel described below with reference to FIGS. 7 and 8.

Referring to FIG. 1, a display device 1 may include a display panel 10. The display panel 10 may display an image.

The display device 1 may include a first long side LS1, a second long side LS2 opposite to the first long side LS1, a first short side SS1 adjacent to the first long side LS1 and the second long side LS2, and a second short side SS2 opposite to the first short side SS1. Meanwhile, for convenience of explanation, it is illustrated that the lengths of the first and second long sides LS1 and LS2 are longer than the lengths of the first and second short sides SS1 and SS2, but it may be possible that the lengths of the first and second long sides LS1 and LS2 are approximately the same as the lengths of the first and second short sides SS1 and SS2.

The direction parallel to the long sides LS1 and LS2 may be referred to as a left-right direction. The first short side SS1 side may be referred to as a left (Le, x), and the second short side SS2 may be referred to as a right Ri.

The direction parallel to the short sides SS1 and SS2 may be referred to as the up-down direction. The first long side LS1 may be referred to as an upper side (U, y), and the second long side LS2 may be referred to as a lower side D.

The direction perpendicular to the long sides LS1, LS2 and the short sides SS1, SS2 may be referred to as a front-rear direction. The direction in which the display panel 10 displays an image may be referred to as a forward direction (F, z), and the opposite direction may be referred to as a rearward direction R.

The long sides LS1, LS2 and the short sides SS1, SS2 may be referred to as edges of the display device 1. A point where the long sides LS1, LS2 and the short sides SS1, SS2 meet each other may be referred to as corners. A first corner Ca may be a point where the first short side SS1 and the first long side LS1 meet. A second corner Cb may be a point where the first long side LS1 and the second short side SS2 meet. A third corner Cc may be a point where the second short side SS2 and the second long side LS2 meet. A fourth corner Cd may be a point where the second long side LS2 and the first short side SS1 meet.

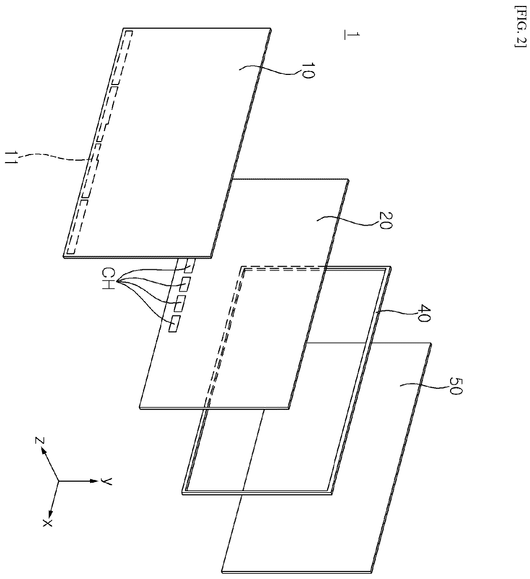

Referring to FIG. 2, the display device 1 may include a display panel 10, a frame 20, a side frame 40, and a back cover 50.

The display panel 10 may form the front surface of the display device 1, and may display an image forward. The display panel 10 may output an image composed of a plurality of pixels, and the color, brightness, and saturation of each pixel may be adjusted. The display panel 10 may generate light corresponding to the color of red, green, or blue according to a control signal. The display panel 10 may be divided into an active area where an image is displayed and a de-active area where an image is not displayed. The display panel 10 may be an Organic Light Emitting Diode (OLED) panel.

The frame 20 may be located at the rear of the display panel 10, and the display panel 10 may be coupled to the frame 20. For example, the frame 20 may include a metal material. The frame 20 may be referred to as a cover bottom 20, a module cover 20, or a PCB plate 20.

The side frame 40 may extend along the edge of the frame 20, and may be coupled to the frame 20. The side frame 40 may cover the side surfaces of the display panel 10 and the frame 20. The side frame 40 may be referred to as a middle cabinet 40 or a guide panel 40.

The back cover 50 may be located at the rear of the frame 20, and may be coupled to the frame 20. The back cover 50 may include a plastic or metal material.

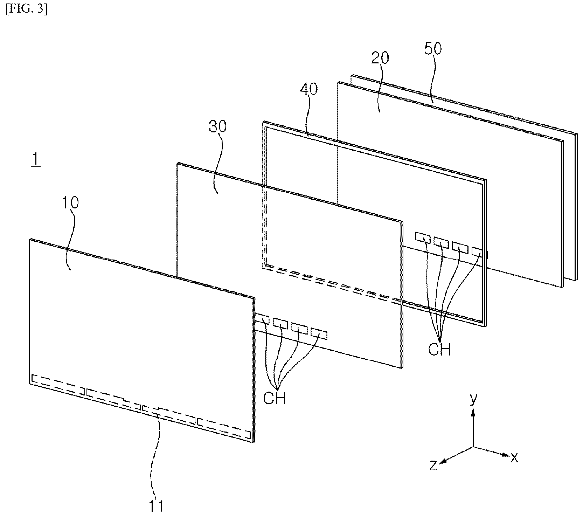

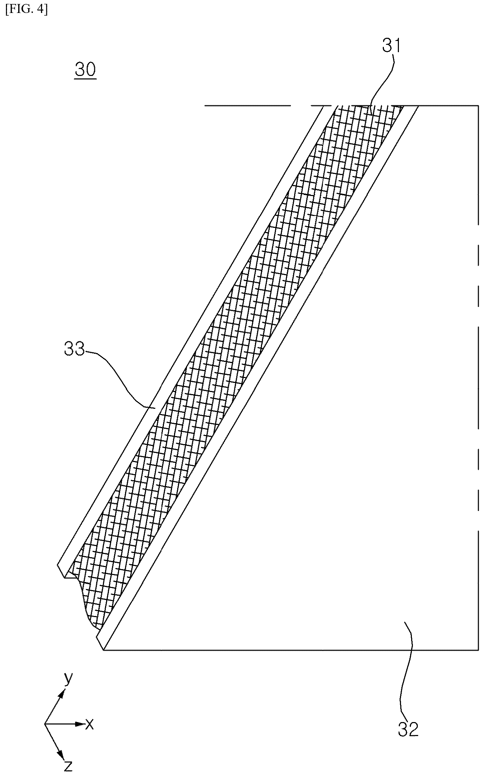

Referring to FIGS. 3 and 4, the display device 1 may include a plate 30. The plate 30 may be located between the display panel 10 and the frame 20, and may be coupled to the display panel 10 and the frame 20. A side frame 40 may cover the side surfaces of the display panel 10, the plate 30, and the frame 20. The side frame 40 may be located between the plate 30 and the frame 20, and may be coupled to the plate 30 and the frame 20. Alternatively, the side frame 40 may be located between the frame 20 and the back cover 50, and may be coupled to the frame 20.

For example, the plate 30 may include a core 31, a front skin 32, and a rear skin 33.

The front skin 32 may form the front surface of the plate 30. The rear skin 33 may form the rear surface of the plate 30. The front skin 32 and the rear skin 33 may be pressed onto a core 31 through a roll-to-roll process using multiple rollers.

The core 31 may be located between the front skin 32 and the rear skin 33. For example, the core 31 may be formed of a composite material, and may include a main fiber and a binder fiber mixed between the main fibers. As another example, the core 31 may have a corrugated shape with wavy folds.

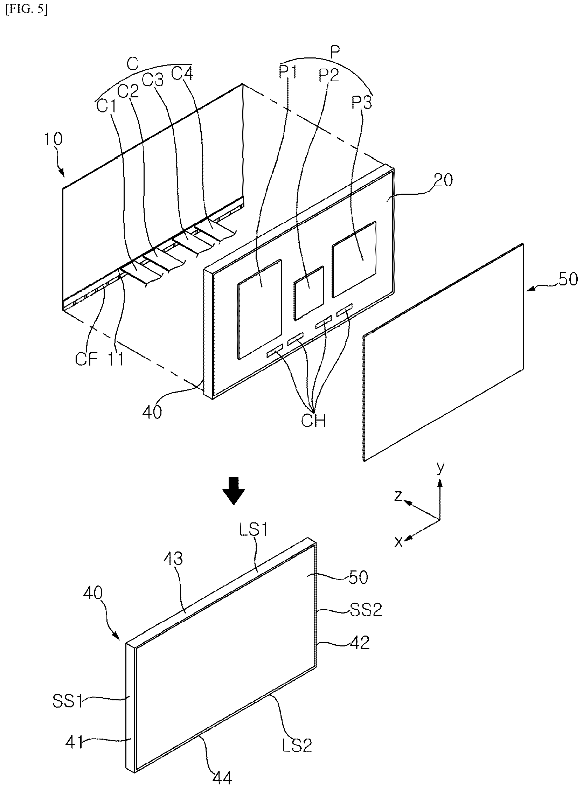

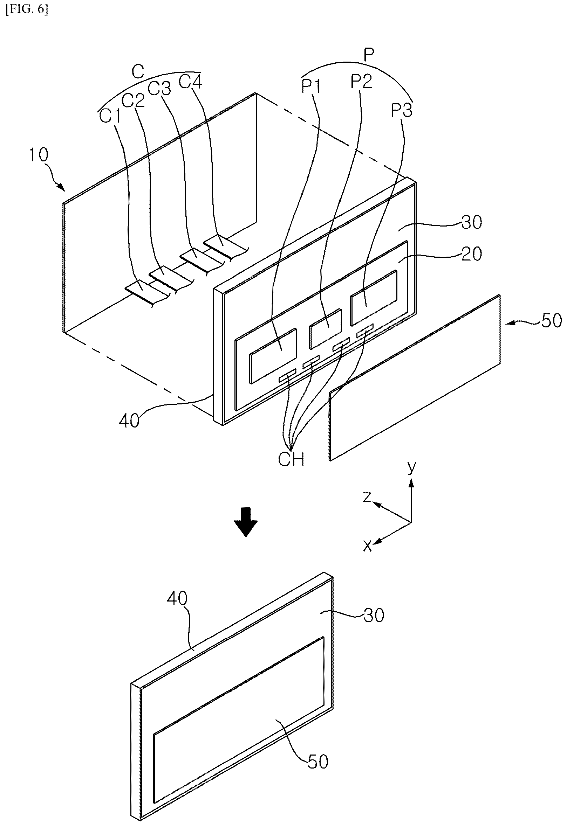

Referring to FIGS. 5 and 6, a plurality of boards P may be mounted on the rear surface of the frame 20, and electrically connected to electronic components of the display device. The board P may be a printed circuit board (PCB), and components may be mounted on the board P. A power supply board P1 may provide power to each component of the display device. A timing controller board P2 may provide a video signal to the display panel 10. The timing controller board P2 may be referred to as a T-CON board P2, T-CON P2, or board P2. A main board P3 may control each component of the display device. For example, the power supply board P1 may be adjacent to the left side of the frame 20, the main board P3 may be adjacent to the right side of the frame 20, and the timing controller board P2 may be located between the power supply board P1 and the main board P3.

A source PCB 11 may be adjacent to the lower side of the display panel 10, and may extend along the lower side. A cable CF may connect the lower side of the display panel 10 and the source PCB 11. For example, the cable CF may be a Chip On Film (COF). A cable C connected to the source PCB 11 may be electrically connected to the timing controller board P2 through a hole CH formed in the plate 30 and the frame 20. For example, the cable C may be an Flexible Flat Cable (FFC).

For example, the frame 20 may have an area corresponding to the plate 30 (see FIGS. 3 and 5). In this case, the back cover 50 may completely cover the rear surface of the frame 20.

For another example, the frame 20 may have an area smaller than the plate 30 (see FIG. 6). In this case, the back cover 50 may cover the rear surface of the frame 20, and a portion of the plate 30 may not be covered by the back cover 50.

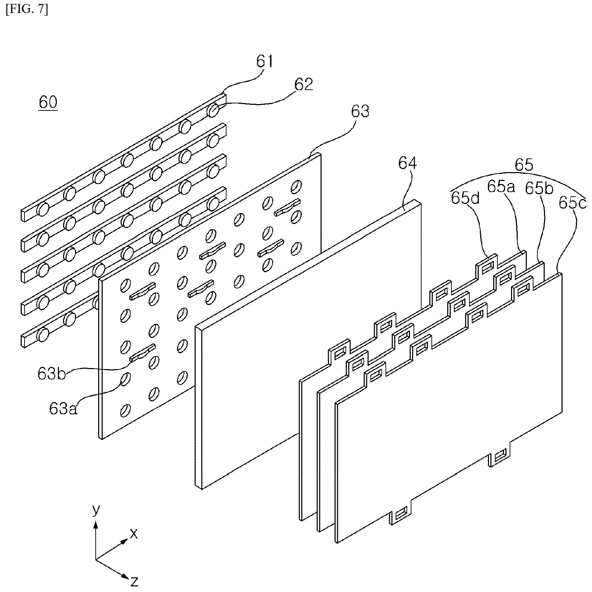

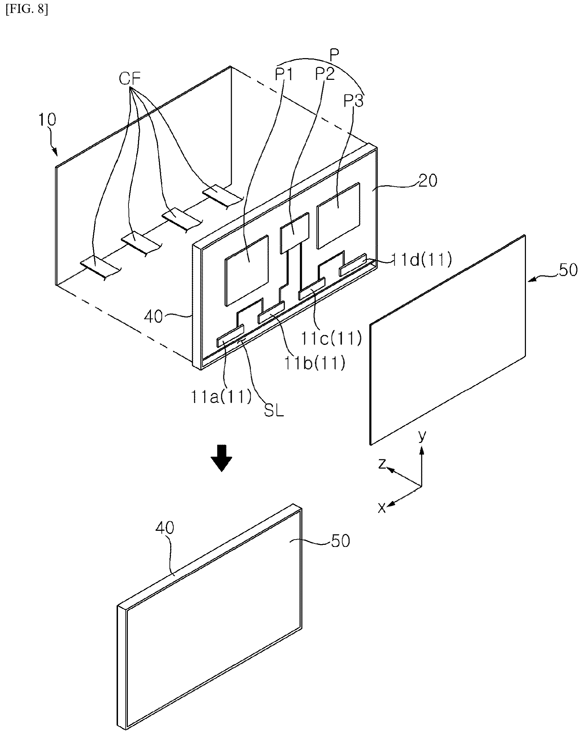

Referring to FIGS. 7 and 8, the display panel 10 may be an Liquid Crystal Display (LCD) panel. The backlight unit 60 may be located between the display panel 10 and the frame 20, may be mounted on the frame 20, and may provide light to the display panel 10. The backlight unit 60 may include a substrate 61, a light source 62, a reflective sheet 63, a diffusion plate 64, and an optical sheet 65.

The substrate 61 may be mounted on THE frame 20, and may have a plate shape or be composed of a plurality of bars. A plurality of light sources 62, such as light emitting diodes (LEDs), may be mounted on the substrate 61. The reflective sheet 63 may cover the substrate 61, and may have holes 63a in which the light sources 62 are located. The diffusion plate 64 may be spaced forward from the reflective sheet 63, and may be supported by a supporter 63b on the reflective sheet 63. The optical sheet 65 may be located between the diffusion plate 64 and the display panel 10.

The source PCB 11 may be adjacent to the lower side of the frame 20, and may be mounted on the rear surface of the frame 20. The cable CF may be electrically connected to the display panel 10 while being adjacent to the lower side of the display panel 10, and may be electrically connected to the source PCB 11 through a slit SL formed on the lower side of the frame 20. For example, the cable CF may be a Chip On Film (COF). The cable (no reference numeral) may electrically connect the source PCB 11 and the timing controller board P2. For example, the cable may be a Flexible Flat Cable (FFC).

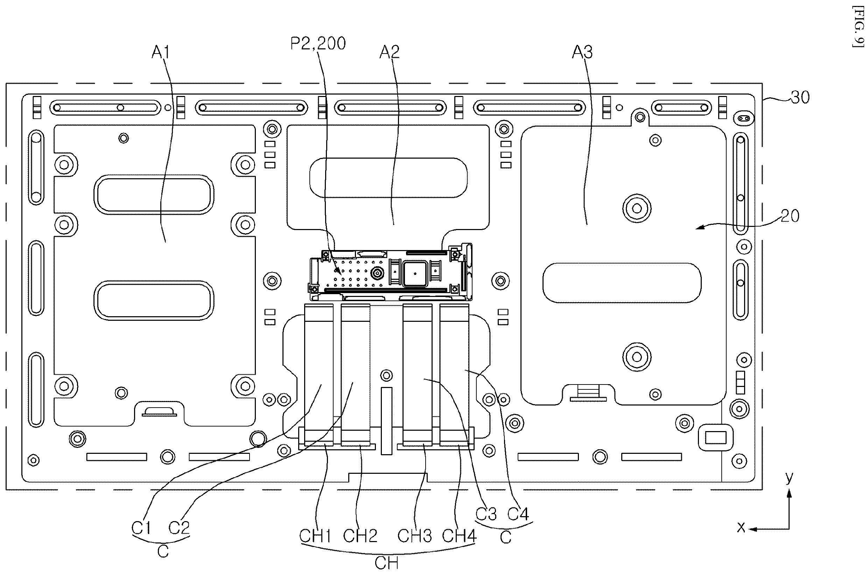

Referring to FIG. 9, the rear surface of the frame 20 may include a left area A 1, a center area A2, and a right area A3. For example, the timing controller board P2 may be coupled to the central area A2, and electrically connected to a plurality of cables C1, C2, C3, C4. A shield 200 may cover the rear of the timing controller board P2, and may be coupled to the timing controller board P2. The shield 200 may be referred to as a cover 200.

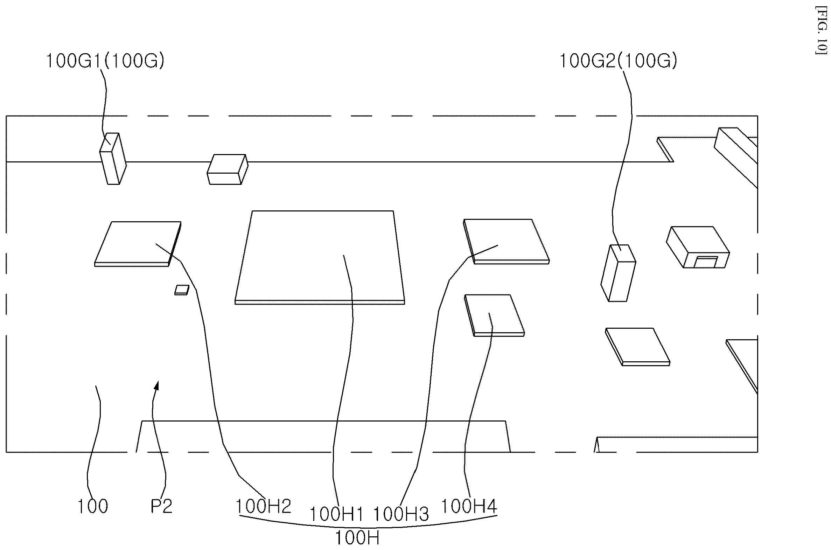

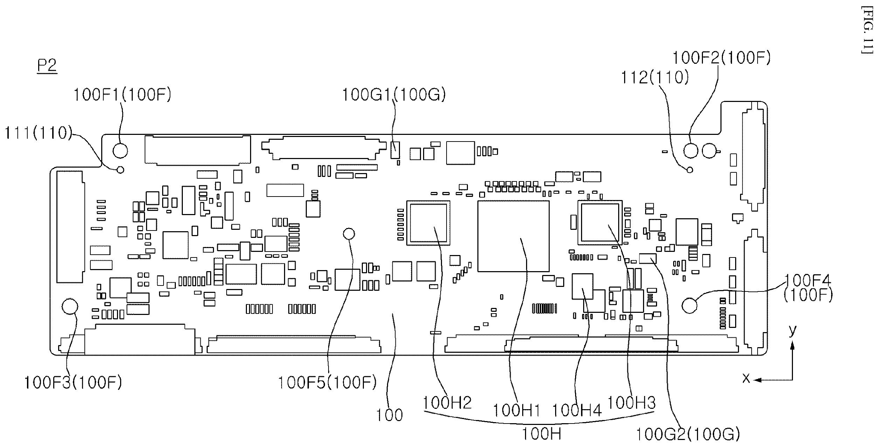

Referring to FIGS. 10 and 11, the timing controller board P2 may have an overall rectangular plate shape. The timing controller board P2 may include a substrate 100 and a plurality of components mounted on the rear surface of the substrate 100. The components may protrude rearward from the rear surface of the substrate 100.

A heat-generating element 100H may be mounted on the rear surface of the substrate 100. The heat-generating element 100H may be a component that generates heat when current flows through it. For example, the heat-generating element 100H may be an IC chip or a system on chip (SOC). The plurality of heat-generating elements 100H1, 100H2, 100H3, 100H4 may be adjacent to each other on the rear surface of the substrate 100, but spaced apart from each other.

A gasket 100G may be mounted on the rear surface of the substrate 100. The gasket 100G may be in contact with the front surface of the shield 200 (see FIG. 9), and the substrate 100 may be grounded to the shield 200 through the gasket 100G, or may be grounded to the frame 20 (to which the shield is coupled through a fastening member) through the gasket 100G and the shield 200. A plurality of gaskets 100G1, 100G2 may be spaced apart from each other on the rear surface of the substrate 100.

A plurality of through holes 100F may be formed to penetrate the substrate 100. A first through hole 100F1 may be adjacent to the left side and the upper side of the substrate 100. A second through hole 100F2 may be adjacent to the right side and the upper side of the substrate 100. A third through hole 100F3 may be adjacent to the left side and the lower side of the substrate 100. A fourth through hole 100F4 may be adjacent to the right side and the lower side of the substrate 100. A fifth through hole 100F5 may be located in the central portion of the substrate 100 or in an area adjacent thereto.

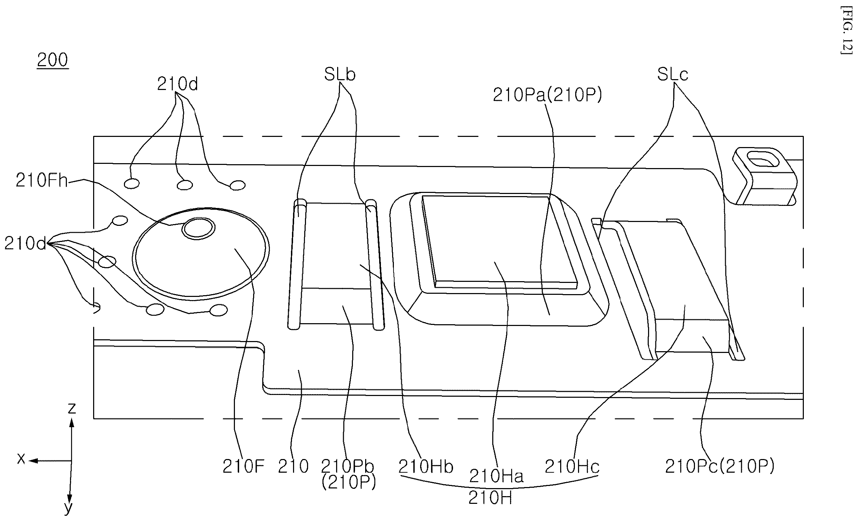

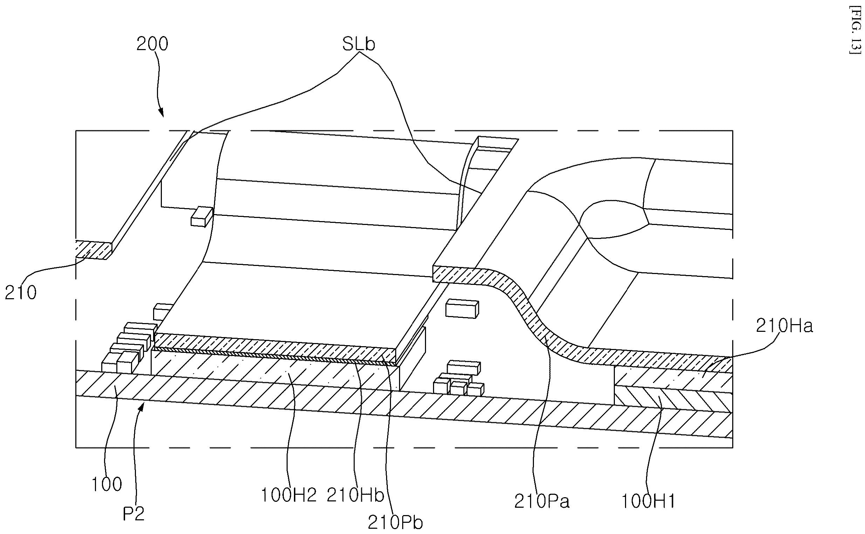

Referring to FIGS. 12 and 13, the shield 200 may be located at the rear of the timing controller board P2. The shield 200 may include a body 210, a mounting portion 210P, a pad 210H, and a fastening portion 210F.

The body 210 may have a shape corresponding to the substrate 100. The body 210 may be spaced rearward from the substrate 100.

The mounting portion 210P may protrude from the body 210 toward the substrate 100. For example, the mounting portion 210P may be formed by pressing forward from the rear surface of the body 210. The plurality of mounting portions 210Pa, 210Pb, 210Pc may face the plurality of heat-generating elements 100H1, 100H2, 100H3, 100H4 on the substrate 100. A first mounting portion 210Pa may face a first heat-generating element 100H1. A second mounting portion 210Pb may face a second heat-generating element 100H2. Slits SLb may be formed between the body 210 and the second mounting portion 210Pb. A third mounting portion 210Pc may face third and fourth heat-generating elements 100H3, 100H4 (see FIG. 11). The slits SLc may be formed between the body 210 and the third mounting portion 210Pc.

The pad 210H may be located between the mounting portion 210P and the heat-generating element 100H, and may be coupled or attached to the mounting portion 210P. The pad 210H may be in contact with the heat-generating element 100H. The pad 210H may be referred to as a thermal pad 210H. A first pad 210Ha may be in contact with or be attached to the rear surface of the first heat-generating element 100H1. A second pad 210Hb may be in contact with or be attached to the rear surface of the second heat-generating element 100H2. A third pad 210Hc may be in contact with or be attached to the rear surfaces of the third and fourth heat-generating elements 100H3, 100H4 (see FIG. 11).

Accordingly, heat from the heat-generating element 100H may be transferred to the shield 200 through the pad 210H. A plurality of heat dissipation holes 210d may be formed in the body 210 while being adjacent to the mounting portion 210P.

A fastening portion 210F may protrude from the body 210 toward the substrate 100. For example, the fastening portion 210F may be formed by pressing forward from the rear surface of the body 210. A fifth fastening hole 210Fh may be formed in the center of the fastening portion 210F.

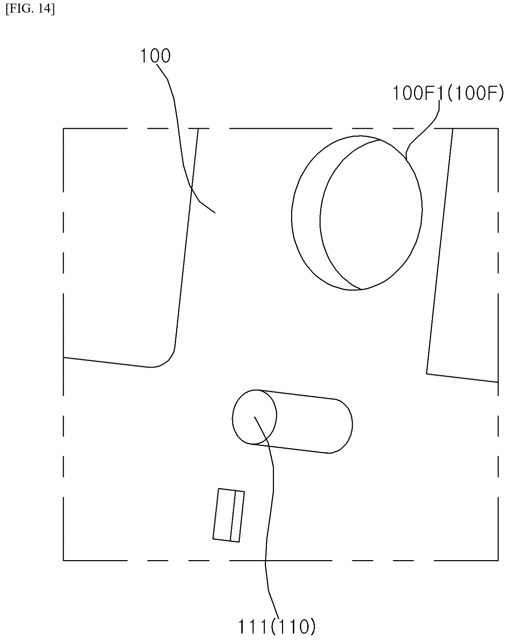

Referring to FIGS. 14 and 11, a guide pin 110 may protrude rearward from the substrate 100 of the timing controller board P2. The guide pin 110 may be formed on the substrate 100. For example, the guide pin 110 may be welded to the substrate 100. The guide pin 110 may be coupled to the substrate 100 through a surface mount technology (SMT). The guide pin 110 may be referred to as a boss 110, a protrusion 110, or a rib 110. A pair of guide pins 111, 112 may be spaced apart from each other on the substrate 100. Alternatively, the number of guide pins 110 may be three or more.

For example, a first guide pin 111 may be adjacent to the first through hole 100F1 of the substrate 100. The first guide pin 111 may be referred to as a first protrusion 111. For example, a second guide pin 112 may be adjacent to the second through hole 100F2 of the substrate 100. The second guide pin 112 may be referred to as a second protrusion 112.

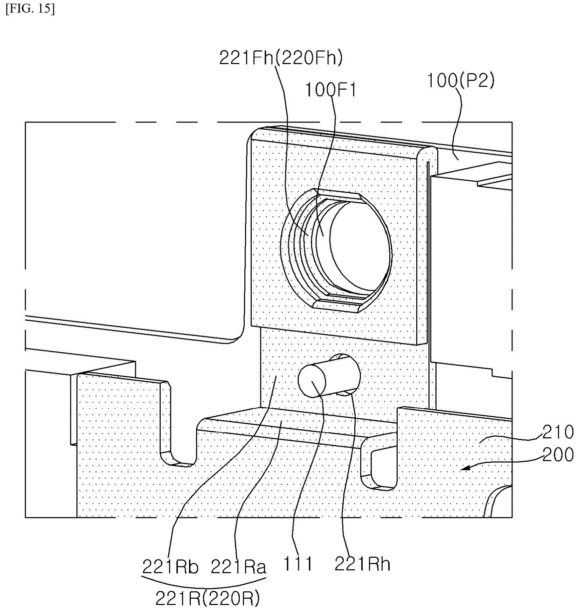

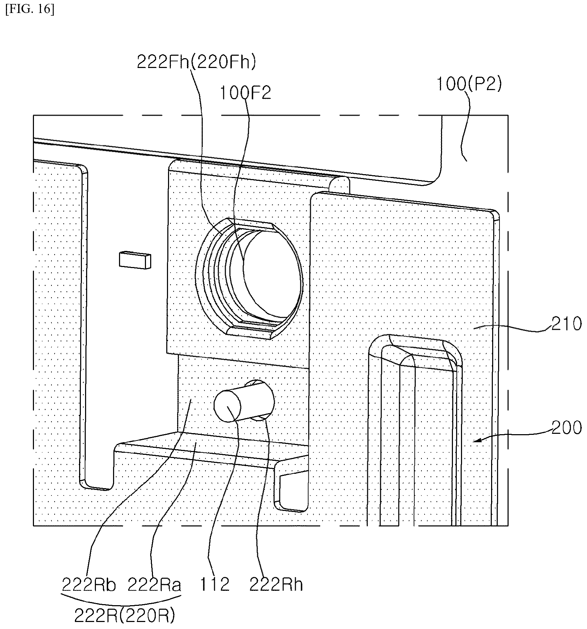

Referring to FIGS. 15 and 16, the rib 220R of the shield 200 may protrude from the body 210 toward the substrate 100 of the timing controller board P2. The rib 220R may protrude from the edge of the body 210, and may be bent at least once. The rib 220R may include a first rib 221R and a second rib 222R.

The first rib 221R may include a first vertical rib 221Ra and a first horizontal rib 221Rb. The first vertical rib 221Ra may be bent from the upper side of the body 210 toward the substrate 100. The first horizontal rib 221Rb may be bent from the first vertical rib 221Ra in a direction intersecting with the first vertical rib 221Ra, and may be arranged parallel to the substrate 100. For example, the first horizontal rib 221Rb may be folded at least once to increase its thickness.

A first pin hole 221Rh may be formed by penetrating the first horizontal rib 221Rb forward and backward. The first guide pin 111 may penetrate the first pin hole 221Rh. The first pin hole 221Rh may be referred to as a first insertion hole 2221Rh. The diameter of the first pin hole 221Rh may be equal to or greater than the diameter of the first guide pin 111. The rear end of the first guide pin 111 may be located at a rear than the rear surface of the first horizontal rib 221Rb. The length or height (i.e., the height at which the first guide pin 111 protrudes rearward from the substrate 100) of the first guide pin 111 may be greater than a sum of the thickness of the first horizontal rib 221Rb and the gap between the first horizontal rib 221Rb and the substrate 100. Here, the gap between the first horizontal rib 221Rb and the substrate 100 (i.e., the lifting amount of the first horizontal rib 221Rb) may be defined in a state in which the shield 200 is mounted on the heat-generating element 100H and/or the gasket 100G (see FIG. 11).

The second rib 222R may include a second vertical rib 222Ra and a second horizontal rib 222Rb. The second vertical rib 222Ra may be bent from the upper side of the body 210 toward the substrate 100. The second horizontal rib 222Rb may be bent from the second vertical rib 222Ra in a direction intersecting with the second vertical rib 222Ra, and may be arranged parallel to the substrate 100. For example, the second horizontal rib 222Rb may be folded at least once to increase its thickness.

A second pin hole 222Rh may be formed by penetrating the second horizontal rib 222Rb in a front-rear direction. The second guide pin 112 may penetrate the second pin hole 222Rh. The second pin hole 222Rh may be referred to as a second insertion hole 222Rh. The diameter of the second pin hole 222Rh may be equal to or larger than the diameter of the second guide pin 112. The rear end of the second guide pin 112 may be located at a rear than the rear surface of the second horizontal rib 222Rb. The length or height (i.e., the height at which the second guide pin 112 protrudes rearward from the substrate 100) of the second guide pin 112 may be larger than a sum of the thickness of the second horizontal rib 222Rb and a gap between the second horizontal rib 222Rb and the substrate 100. Here, the gap between the second horizontal rib 222Rb and the substrate 100 (i.e., the lifting amount of the second horizontal rib 222Rb) may be defined in a state in which the shield 200 is mounted on the heat-generating element 100H and/or the gasket 100G (see FIG. 11).

Accordingly, the first and second guide pins 111, 112 engaged by the body 210 may restrict the shield 200 mounted on the heat-generating element 100H and/or the gasket 100G from rotating around a forward-rearward axis.

A first fastening hole 221Fh may be formed by penetrating the first horizontal rib 221Rb in a forward-rearward direction. For example, the first fastening hole 221Fh may be formed in a portion where part of the first horizontal rib 221Rb overlaps with another part.

A second fastening hole 222Fh may be formed by penetrating the second horizontal rib 222Rb in a forward-rearward direction. For example, the second fastening hole 222Fh may be formed in a portion where part of the second horizontal rib 222Rb overlaps with another part.

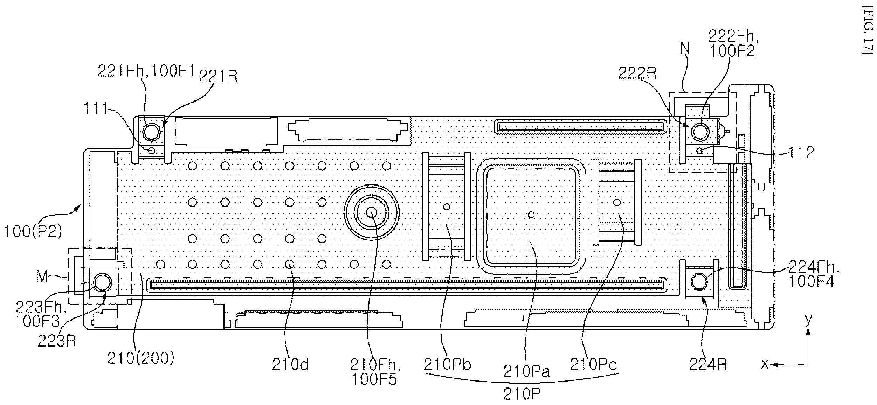

Referring to FIG. 17, the shield 200 may further include third and fourth ribs 223R, 224R in addition to the first and second ribs 221R, 222R described above.

A third vertical rib of the third rib 223R may protrude from the left side of the body 210 toward the substrate 100. The third horizontal rib of the third rib 223R may intersect with the third vertical rib, and may have a third fastening hole 223Fh.

A fourth vertical rib of the fourth rib 224R may protrude from the lower side of the body 210 toward the substrate 100. The fourth horizontal rib of the fourth rib 224R may intersect with the fourth vertical rib, and may have a fourth fastening hole 224Fh.

When the shield 200 engages with the first and second guide pins 111, 112 of the timing controller board P2, the plurality of fastening holes 221Fh, 222Fh, 223Fh, 224Fh, 210Fh of the shield 200 may be aligned with the plurality of through holes 100F1, 100F2, 100F3, 100F4, 100F5 of the timing controller board P2.

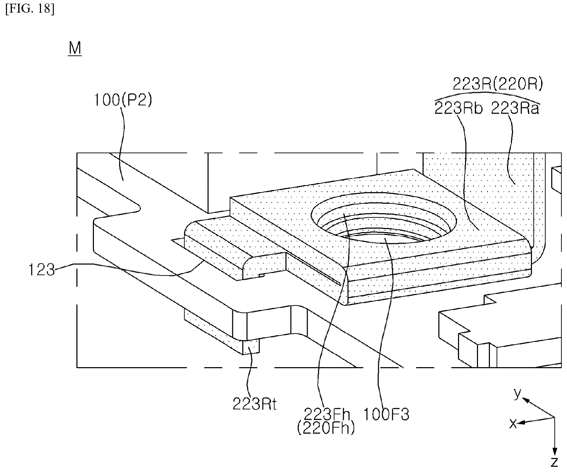

Alternatively, as described later in FIGS. 18 to 23, when the guide ribs of the shield 200 engage with the guide holes of the timing controller board P2, the plurality of fastening holes 221Fh, 222Fh, 223Fh, 224Fh, 210Fh of the shield 200 may be aligned with the plurality of through holes 100F1, 100F2, 100F3, 100F4, 100F5 of the timing controller board P2.

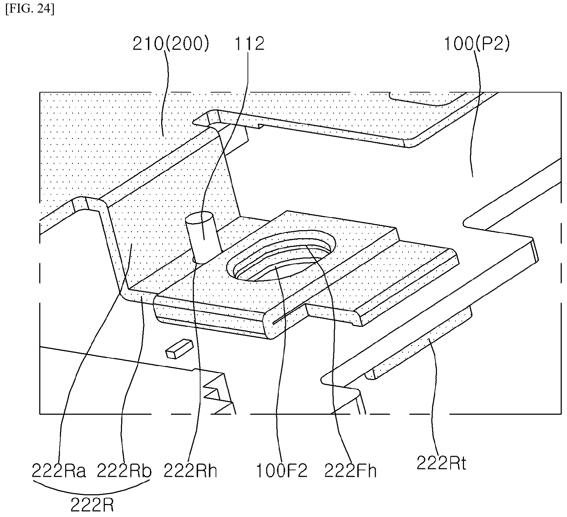

Alternatively, as described later in FIG. 24, when the shield 200 engages with the first and second guide pins 111, 112 of the timing controller board P2 and the guide ribs of the shield 200 engage with the guide holes of the timing controller board P2, the plurality of fastening holes 221Fh, 222Fh, 223Fh, 224Fh, 210Fh of the shield 200 may be aligned with the plurality of through holes 100F1, 100F2, 100F3, 100F4, 100F5 of the timing controller board P2.

Accordingly, the first fastening hole 221Fh may be aligned with the first through hole 100F1, the second fastening hole 222Fh may be aligned with the second through hole 100F2. The third fastening hole 223Fh may be aligned with the third through hole 100F3, and the fourth fastening hole 224Fh may be aligned with the fourth through hole 100F4. The fifth fastening hole 210Fh may be aligned with the fifth through hole 100F5.

Fastening members such as a screw may be fastened to the frame 20 (see FIG. 9) through fastening holes 221Fh, 222Fh, 223Fh, 224Fh, 210Fh and through holes 100F 1, 100F2, 100F3, 100F4, 100F5. Screw threads that engage with the screw threads of the fastening members may be formed on the inner surface of the coupling portion of the frame 20. Accordingly, the shield 200 may be coupled to the timing controller board P2, and the shield 200 and the timing controller board P2 may be mounted on the frame 20. Since the shield 200 is aligned in a correct position on the timing controller board P2 by the guide pins 111, 112 and/or the guide ribs, the fastening of these fastening members may not require many workers and may be performed automatically by a robot.

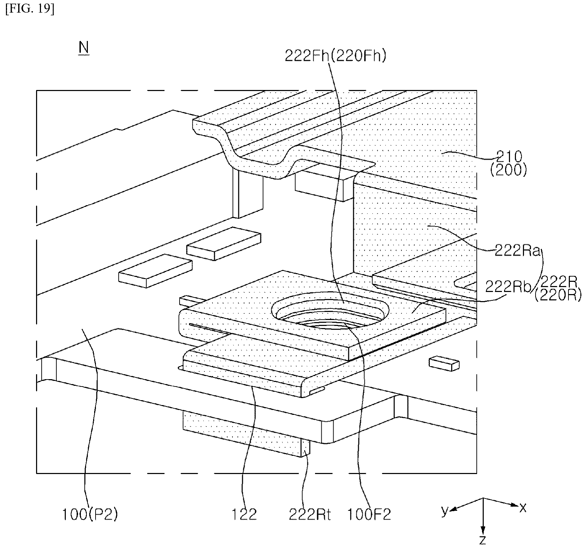

Referring to FIGS. 18 and 19, the third rib 223R may include a third vertical rib 223Ra, a third horizontal rib 223Rb, and a first guide rib 223Rt. The third fastening hole 223Fh may be formed in the third horizontal rib 223Rb. The first guide rib 223Rt may be referred to as a first protrusion 223Rt.

The first guide rib 223Rt may be bent forward from the third horizontal rib 223Rb, and may penetrate the first guide hole 123. The first guide hole 123 may be formed to penetrate the substrate 100 of the timing controller board P2 in a front-rear direction. The first guide hole 123 may be referred to as a first insertion hole 123. The first guide hole 123 may have a slot shape, and may have a length and width equal to or greater than those of the first guide rib 223Rt. The front end of the first guide rib 223Rt may be located forward of the front surface of the substrate 100. The height (i.e., the height at which the first guide rib 223Rt protrudes forward from the third horizontal rib 223Rb) of the first guide rib 223Rt may be greater than the sum of the thickness of the substrate 100 and the gap between the third horizontal rib 223Rb and the substrate 100. Here, the gap (i.e., the lifting amount of the third horizontal rib 223Rb) between the third horizontal rib 223Rb and the substrate 100 may be defined in a state where the shield 200 is mounted on the heat-generating element 100H and/or the gasket 100G (see FIG. 17).

The second rib 222R may include a second vertical rib 222Ra, a second horizontal rib 222Rb, and a second guide rib 222Rt. The second fastening hole 222Fh may be formed in the second horizontal rib 222Rb. The second guide rib 222Rt may be referred to as a second protrusion 222Rt.

The second guide rib 222Rt may be bent forward from the second horizontal rib 222Rb, and may penetrate the second guide hole 122. The second guide hole 122 may be formed by penetrating the substrate 100 of the timing controller board P2 in a front-rear direction. The second guide hole 122 may be referred to as a second insertion hole 122. The second guide hole 122 may have a slot shape, and may have a length and width equal to or greater than the second guide rib 222Rt. The front end of the second guide rib 222Rt may be located forward of the front surface of the substrate 100. The height (i.e., the height at which the second guide rib 222Rt protrudes forward from the second horizontal rib 22Rb) of the second guide rib 222Rt may be greater than the sum of the thickness of the substrate 100 and the gap between the second horizontal rib 222Rb and the substrate 100. Here, the gap (i.e., the lifting amount of the second horizontal rib 222Rb) between the second horizontal rib 222Rb and the substrate 100 may be defined in a state in which the shield 200 is mounted on the heat-generating element 100H and/or the gasket 100G (see FIG. 17).

Accordingly, the first and second guide ribs 223Rt, 222Rt that engage with the first and second guide holes 123, 122 may restrict the shield 200 mounted on the heat-generating element 100H and/or the gasket 100G from rotating around a forward-rearward axis.

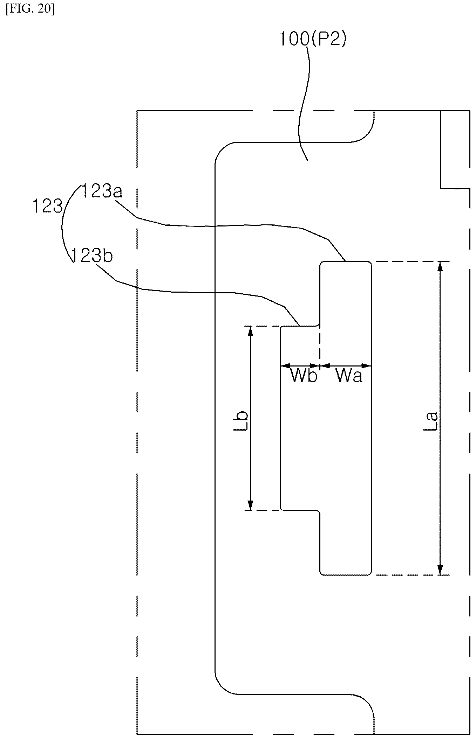

Referring to FIGS. 20 to 22, the first guide hole 123 may include a first hole 123a and a second hole 123b. The first guide hole 123 may have an overall stepped shape. A portion of the second hole 123b may be shared with the first hole 123a. The length La of the first hole 123a may be greater than the length Lb of the second hole 123b, and the width Wa of the first hole 123a may be less than the width (Wa+Wb) of the second hole 123b. Meanwhile, the second guide hole 122 (see FIG. 19) described above may also be modified like the first guide hole 123.

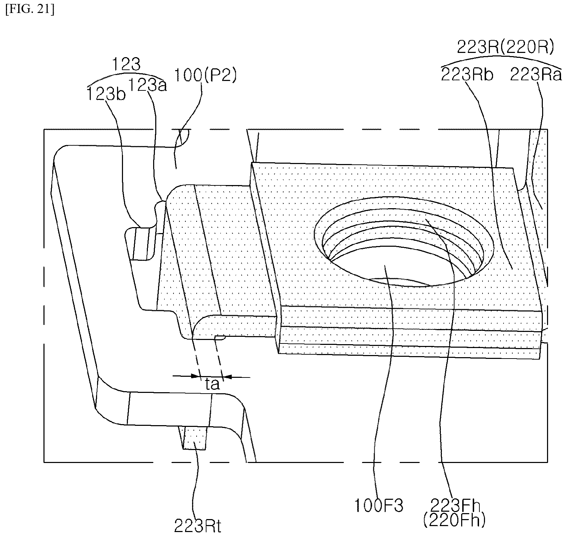

Referring to FIG. 21, the first guide rib 223Rt may penetrate the first hole 123a, and be spaced apart from a portion of the second hole 123b that is not shared with the first hole 123a. The thickness ta of the first guide rib 223Rt may be equal to or less than the width Wa of the first hole 123a, and the length of the first guide rib 223Rt may be equal to or less than the length La of the first hole 123a.

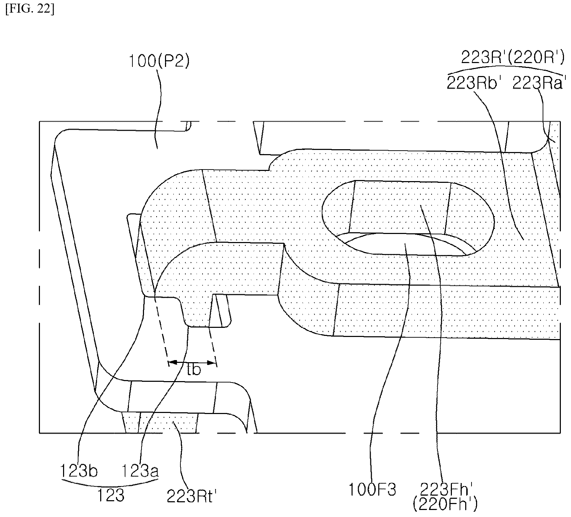

Referring to FIG. 22, the first guide rib 223Rt' may penetrate the second hole 123b, and be spaced apart from a portion of the first hole 123a that is not shared with the second hole 123b. The thickness tb of the first guide rib 223Rt' may be equal to or less than the width (Wa+Wb) of the second hole 123b, and the length of the first guide rib 223Rt' may be equal to or less than the length Lb of the second hole 123b. Here, the thickness tb (see FIG. 22) may be greater than the thickness ta (see FIG. 21).

Accordingly, any one of the first guide ribs 223Rt, 223Rt' of different thicknesses may penetrate the first guide hole 123. For example, the thickness of the first guide rib 223Rt; 223Rt' may be equal to the thickness of the rib (220R; 220R') and the thickness of the shield body.

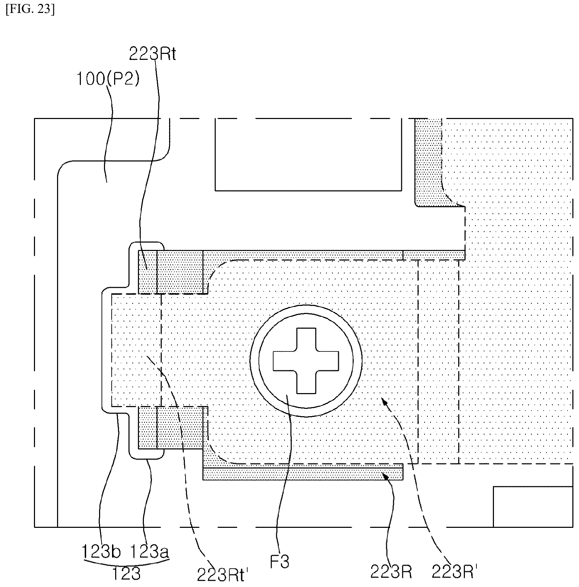

Referring to FIG. 23, a fastening member F3, such as a screw, may be fastened to the frame 20 (see FIG. 9) through the third fastening hole 223Fh (see FIG. 21), 223Fh' (see FIG. 22) and the third through hole 100F3. The screw threads that engage with the screw threads of the fastening member F3 may be formed on the inner surface of the coupling portion of the frame 20. Similarly, the fastening members may be fastened to the frame 20 (see FIG. 9) through the remaining fastening holes 221Fh, 222Fh, 224Fh, 210Fh and the remaining through holes 100F1, 100F2, 100F4, 100F5 (see FIG. 17). Accordingly, the shield 200 may be coupled to the timing controller board P2, and the shield 200 and the timing controller board P2 may be mounted on the frame 20.

Referring to FIG. 24, the second horizontal rib 222Rb of the shield 200 may engage with the second guide pin 112 of the timing controller board P2, and the second guide rib 222Rt of the shield 200 may penetrate the timing controller board P2 and engage with it.

Accordingly, before fixing the shield 200 to the timing controller board P2 through a fastening member such as a screw, the shield 200 may be more stably secured on the timing controller board P2 and may not rotate.

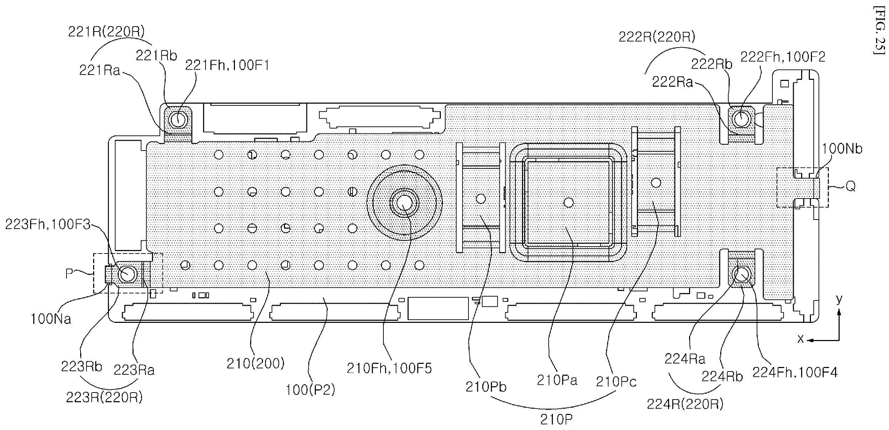

Referring to FIG. 25, the shield 200 may include a first rib 221R, a second rib 222R, a third rib 223R, and a fourth rib 224R.

The first vertical rib 221Ra of the first rib 221R may be adjacent to the left side of the body 210 and may protrude from the upper side of the body 210 toward the substrate 100. The first horizontal rib 221Rb of the first rib 221R may be bent in a direction intersecting with the first vertical rib 221Ra from the first vertical rib 221Ra. The first horizontal rib 221Rb may be arranged parallel to the substrate 100. The first fastening hole 221Fh may be formed by penetrating the first horizontal rib 221Rb in a front-rear direction, and may be aligned with the first through hole 00F1 (see FIG. 11).

The second vertical rib 222Ra of the second rib 222R may be adjacent to the right side of the body 210 and may protrude from the upper side of the body 210 toward the substrate 100. The second horizontal rib 222Rb of the second rib 222R may be bent from the second vertical rib 222Ra in a direction intersecting with the second vertical rib 222Ra. The second horizontal rib 222Rb may be arranged parallel to the substrate 100. The second fastening hole 222Fh may be formed by penetrating the second horizontal rib 222Rb in a front-rear direction, and may be aligned with the second through hole 100F2 (see FIG. 11).

The third vertical rib 223Ra of the third rib 223R may be adjacent to the lower side of the body 210 and may protrude from the left side of the body 210 toward the substrate 100. The third horizontal rib 223Rb of the third rib 223R may be bent from the third vertical rib 223Ra in a direction intersecting with the third vertical rib 223Ra. The third horizontal rib 223Rb may be arranged parallel to the substrate 100. The third fastening hole 223Fh may be formed by penetrating the third horizontal rib 223Rb in a front-rear direction, and may be aligned with the third through hole 100F3 (see FIG. 11).

The fourth vertical rib 224Ra of the fourth rib 224R may be adjacent to the right side of the body 210 and may protrude from the lower side of the body 210 toward the substrate 100. The fourth horizontal rib 224Rb of the fourth rib 224R may be bent from the fourth vertical rib 224Ra in a direction intersecting with the fourth vertical rib 224Ra. The fourth horizontal rib 224Rb may be arranged parallel to the substrate 100. The fourth fastening hole 224Fh may be formed by penetrating the fourth horizontal rib 224Rb in a front-rear direction, and may be aligned with the fourth through hole 100F4 (see FIG. 11).

A first groove 100Na may be formed from the first side of the substrate 100 toward the inside of the substrate 100 (see P of FIG. 25). A second groove 100Nb may be formed from the second side of the substrate 100 toward the inside of the substrate 100 (see Q of FIG. 25). The first side and the second side may intersect with or be opposite to each other. For example, the first side may be a left side of the substrate 100, and the second side may be a right side of the substrate 100. The grooves 100Na, 100Nb may be referred to as notches 100Na, 100Nb.

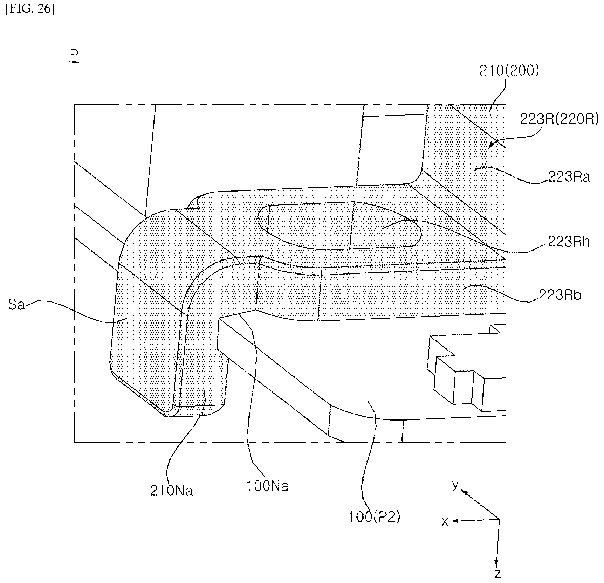

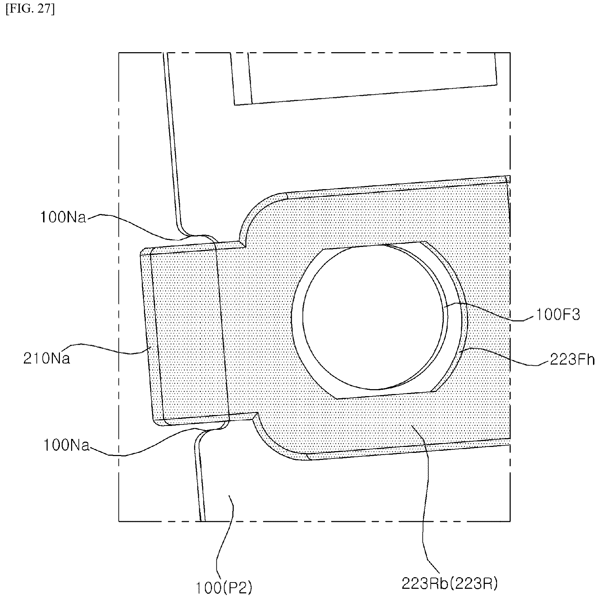

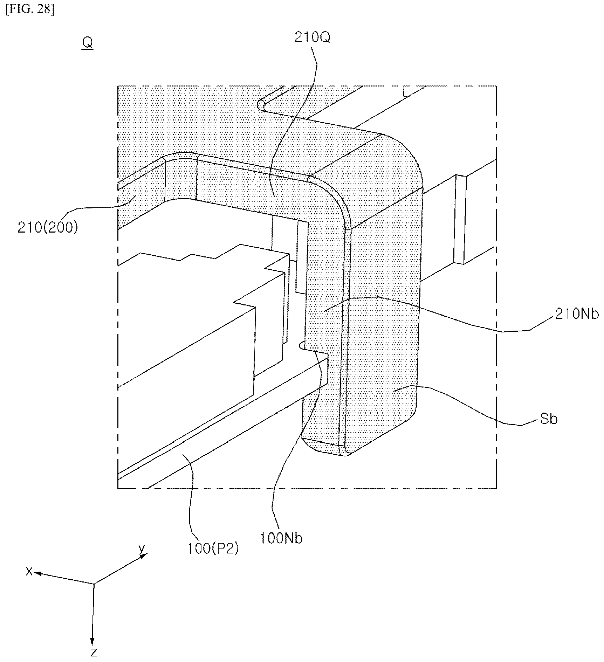

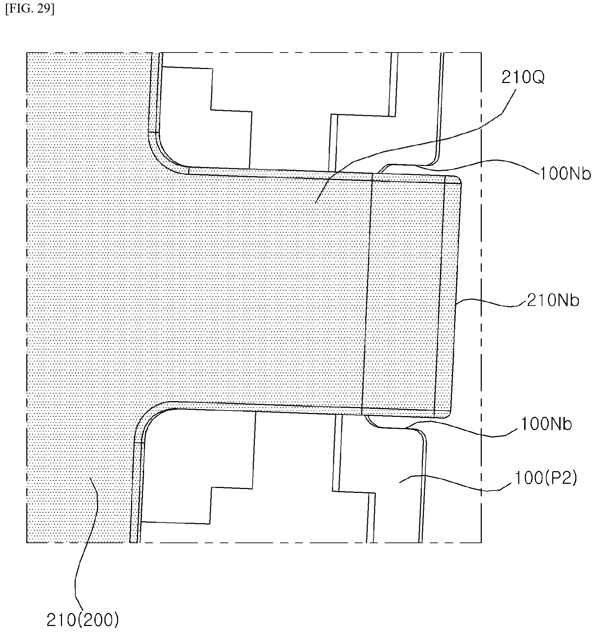

Referring to FIGS. 26 and 27, the first guide rib 210Na may be formed on a first side of the body 210 of the shield 200, and may be inserted into the first groove 100Na formed on the first side of the substrate 100. The first groove 100Na may be formed on the left side of the substrate 100, and may be adjacent to the third rib 223R. The first guide rib 210Na may be bent forward from the distal end of the third horizontal rib 223Rb, and may be inserted into the first groove 100Na. Alternatively, the first guide rib 210Na may be bent forward from the left side of the body 210 and inserted into the first groove 100Na, like the second guide rib 210Nb (see FIGS. 28 and 29) described below.

The front end of the first guide rib 210Na may be located forward of the front surface of the substrate 100. The first guide rib 210Na may engage with the first groove 100Na. The first guide rib 210Na may be referred to as a first protrusion 210Na.

The first groove 100Na may be a rectangular groove, and the first guide rib 210Na may have a rectangular cross-section. Among the four side surfaces of the first guide rib 210Na, the upper surface, lower surface, and right surface may be in contact with or be adjacent to the first groove 100Na, while the left surface Sa may not be in contact with the first groove 100Na. That is, the first groove 100Na may restrict the up-and-down movement and rightward movement of the first guide rib 210Na.

Referring to FIGS. 28 and 29, the second guide rib 210Nb may be formed on the second side of the body 210 of the shield 200, and may be inserted into the second groove 100Nb formed on the second side of the substrate 100. The second groove 100Nb may be formed on the right side of the substrate 100. The second guide rib 210Nb may be bent forward from the right side of the body 210, and inserted into the second groove 100Nb. For example, the right side of the body 210 may be located in the left of the right side of the substrate 100, and an extension portion 210Q may protrude to the right from the right side of the body 210. In this case, the second guide rib 210Nb may be bent forward from the distal end of the extension portion 210Q. Alternatively, the second guide rib 210Nb may be bent forward from a horizontal rib on the substrate 100, like the first guide rib 210Na (see FIGS. 26 and 27), and inserted into the second groove 100Nb.

The front end of the second guide rib 210Nb may be located forward of the front surface of the substrate 100. The second guide rib 210Nb may engage with the second groove 100Nb. The second guide rib 210Nb may be referred to as a second protrusion 210Nb.

The second groove 100Nb may be a rectangular groove, and the second guide rib 210Nb may have a rectangular cross-section. Among the four side surfaces of the second guide rib 210Nb, the upper surface, the lower surface, and the left surface may be in contact with or be adjacent to the second groove 100Nb, and the right surface Sb may not be in contact with the second groove 100Nb. That is, the second groove 100Nb may restrict the up-and-down movement and leftward movement of the second guide rib 210Nb.

Accordingly, when the first guide rib 210Na engages with the first groove 100Na (see FIGS. 26 and 27), and the second guide rib 210Nb engages with the second groove 100Nb, the up-and-down movement and left-right movement of the shield 200 may be restricted. In addition, the rotation of the shield 200 on the timing controller board P2 about an axis parallel to the front-rear direction may also be restricted.

A plurality of fastening holes 221Fh, 222Fh, 223Fh, 224Fh, 210Fh of the shield 200 may be aligned with a plurality of through holes 100F1, 100F2, 100F3, 100F4, 100F5 of the timing controller board P2.

A coupling guide structure of the shield 200 and the timing controller board P2 using these guide ribs 210Na, 210Nb and grooves 100Na, 100Nb has a simpler structure and does not require pins, in comparison with the coupling guide structure (see FIGS. 14 to 17) of the shield 200 and the timing controller board P2 using pins 111, 112 and pin holes 221Ra, 222Rh, thereby reducing costs and having a high compatibility.

In addition, a coupling guide structure of the shield 200 and the timing controller board P2 using these guide ribs 210Na, 210Nb and grooves 100Na, 100Nb may have the advantage of being simple in structure and easily applicable to shields 200 of various thicknesses, in comparison with the coupling guide structure (see FIGS. 17 to 24) of the shield 200 and the timing controller board P2 using guide ribs 222Rt, 223Rt and guide holes 122, 123.

Fastening members such as a screw may be fastened to the frame 20 (see FIG. 9) through fastening holes 221Fh, 222Fh, 223Fh, 224Fh, 210Fh and through holes 100F 1, 100F2, 100F3, 100F4, 100F5. Screw threads that engage with the screw threads of the fastening members may be formed on the inner surface of the coupling portion of the frame 20. Each of the coupling portions of the frame 20 aligned with each of the through holes 100F1, 100F2, 100F3, 100F4, 100F5 may be formed by pressing from the front surface of the frame 20 in a rearward direction, and the screw threads may be formed on the inner surface of the hole of each of the connecting portions.

Accordingly, the shield 200 may be coupled to the timing controller board P2, and the shield 200 and the timing controller board P2 may be mounted on the frame 20. Since the shield 200 is aligned in a correct position on the timing controller board P2 by the guide ribs 210Na, 210Nb and the grooves 100Na, 100Nb, the fastening of these fastening members may not require many workers, and may be performed automatically by a robot.

Referring to FIGS. 1 to 29, a display device according to an aspect of the present disclosure may include: a display panel; a frame which is located behind the display panel, and to which the display panel is coupled; a board including a substrate, and seated on the frame; and a shield covering the board, in which the board may include an element which protrudes from the substrate toward the shield, and on which the shield is seated, and one of the substrate and the shield may include protrusions which protrude from the one to the other to be inserted into the other, and which are spaced apart from each other.

The board may be a timing controller board.

A portion of the shield, excluding a portion seated on the element may be spaced apart from the substrate.

The display device may further include a plurality of fastening members fastened to the frame by penetrating the shield and the board.

The protrusions may include a first guide pin and a second guide pin which protrude from the substrate toward the shield to penetrate the shield, and which are spaced apart from each other, in which the first and second guide pins may restrict rotation of the shield about an axis intersecting with the shield.

The shield may further include: a body seated on the element; and a first rib which protrudes from the body toward the substrate, and through which the first guide pin penetrates.

The shield may cover a rear of the board, and a rear end of the first guide pin may be located rearward of a rear surface of the first rib.

The protrusions may include a first guide rib and a second guide rib which protrude from the shield toward the substrate to penetrate the substrate, and which are spaced apart from each other, in which the first and second guide ribs may restrict rotation of the shield about an axis intersecting with the shield.

The shield may further include: a body seated on the element; a first vertical rib which protrudes from the body toward the substrate; and a first horizontal rib which is bent from the first vertical rib in a direction intersecting with the first vertical rib, and the first guide rib may be bent from the first horizontal rib and penetrates the substrate.

The substrate may include a first guide hole through which the first guide rib penetrates, in which the first guide hole may include: a first hole; and a second hole which shares a portion with the first hole, and has a different size from the first hole.

A length of the first hole may be greater than a length of the second hole, a width of the second hole may be greater than a width of the first hole, and a thickness of the first guide rib may correspond to the width of the first hole or the width of the second hole.

The display device may further includes a fastening member which penetrates the first horizontal rib and the substrate and which is fastened to the frame.

The protrusions may include: a guide pin which protrudes from the substrate toward the shield and which penetrates the shield; and a guide rib which protrudes from the shield toward the substrate and which penetrates the substrate, in which the guide pin and the guide rib may restrict rotation of the shield about an axis intersecting with the shield.

The substrate may include: a first groove formed on a first side of the substrate; and a second groove formed on a second side of the substrate, the shield may include a body seated on the element, the protrusion may include: a first guide rib which protrudes from a first side of the body toward the first groove and which is inserted into the first groove; and a second guide rib which protrudes from a second side of the body toward the second groove and which is inserted into the second groove.

The first side of the substrate and the second side of the substrate may be opposite to each other.

The shield further includes: a first vertical rib protruding from the body toward the substrate; and a first horizontal rib bent from the first vertical rib in a direction intersecting with the first vertical rib, the first guide rib may bebent from the first horizontal rib and may engage with the first guide rib.

The shield may further include an extension portion that protrudes from the body, and the second guide rib may be bent from a distal end of the extension portion and may engage with the second guide rib.

The protrusions may include: a first protrusion adjacent to a first edge of the shield; and a second protrusion adjacent to a second edge of the shield opposite the first edge.

A portion with which the element and the shield come into contact may be located between the first protrusion and the second protrusion.

Certain embodiments or other embodiments of the disclosure described above are not mutually exclusive or distinct from each other. Any or all elements of the embodiments of the disclosure described above may be combined or combined with each other in configuration or function.

For example, a configuration "A" described in one embodiment of the disclosure and the drawings and a configuration "B" described in another embodiment of the disclosure and the drawings may be combined with each other. Namely, although the combination between the configurations is not directly described, the combination is possible except in the case where it is described that the combination is impossible.

The foregoing embodiments are merely examples and are not to be considered as limiting the present disclosure. The scope of the present disclosure should be determined by rational interpretation of the appended claims, and all modifications within the equivalents of the disclosure are intended to be included within the scope of the present disclosure.

## Claims

1. A display device comprising:
a display panel;
a frame which is located behind the display panel, and to which the display panel is coupled;
a board including a substrate and seated on the frame; and
a shield covering the board,
wherein the board comprises an element which protrudes from the substrate toward the shield, and on which the shield is seated, and
one of the substrate and the shield comprises protrusions which protrude from the one to the other to be inserted into the other, and which are spaced apart from each other.

2. The display device of claim 1, wherein the board is a timing controller board.

3. The display device of claim 1, wherein a portion of the shield, excluding a portion seated on the element is spaced apart from the substrate.

4. The display device of claim 1, further comprising a plurality of fastening members passing through the shield and the board and fastened to the frame.

5. The display device of claim 1, wherein the protrusions comprise a first guide pin and a second guide pin which protrude from the substrate toward the shield to pass through the shield, and which are spaced apart from each other,
wherein the first and second guide pins restrict rotation of the shield about an axis intersecting with the shield.

6. The display device of claim 5, wherein the shield further comprises:
a body seated on the element; and
a first rib which protrudes from the body toward the substrate, and through which the first guide pin passes.

7. The display device of claim 6, wherein the shield covers a rear of the board, and
a rear end of the first guide pin is located rearward of a rear surface of the first rib.

8. The display device of claim 1, wherein the protrusions comprise:
a first guide rib and a second guide rib which protrude from the shield toward the substrate to pass through the substrate, and which are spaced apart from each other,
wherein the first and second guide ribs restrict rotation of the shield about an axis intersecting with the shield.

9. The display device of claim 8, wherein the shield further comprises:
a body seated on the element;
a first vertical rib protruding from the body toward the substrate; and
a first horizontal rib bent from the first vertical rib in a direction intersecting with the first vertical rib,
wherein the first guide rib is bent from the first horizontal rib and passes through the substrate.

10. The display device of claim 8, wherein the substrate comprises a first guide hole through which the first guide rib passes,
wherein the first guide hole comprises:
a first hole; and
a second hole which shares a portion with the first hole, and has a different size from the first hole.

11. The display device of claim 10, wherein a length of the first hole is greater than a length of the second hole,
a width of the second hole is greater than a width of the first hole, and
a thickness of the first guide rib corresponds to the width of the first hole or the width of the second hole.

12. The display device of claim 1, wherein the substrate comprises:
a first groove formed on a first side of the substrate; and
a second groove formed on a second side of the substrate,
wherein the shield comprises a body seated on the element,
wherein the protrusion comprises:
a first guide rib which protrudes from a first side of the body toward the first groove and which is inserted into the first groove; and
a second guide rib which protrudes from a second side of the body toward the second groove and which is inserted into the second groove.

13. The display device of claim 12, wherein the first side of the substrate and the second side of the substrate are opposite to each other.

14. The display device of claim 12, wherein the shield further comprises:
a first vertical rib protruding from the body toward the substrate; and
a first horizontal rib bent from the first vertical rib in a direction intersecting with the first vertical rib,
wherein the first guide rib is bent from the first horizontal rib and engages with the first guide rib.

15. The display device of claim 1, wherein the protrusions comprise:
a first protrusion adjacent to a first edge of the shield; and
a second protrusion adjacent to a second edge of the shield opposite the first edge,
wherein a portion with which the element and the shield come into contact is located between the first protrusion and the second protrusion.
